Europäisches Patentamt

European Patent Office

Office européen des brevets

(19)

(11) Veröffentlichungsnummer: **0 186 176**
**A2**

(12) **EUROPÄISCHE PATENTANMELDUNG**

(21) Anmeldenummer: **85116474.9**

(22) Anmeldetag: **23.12.85**

(51) Int. Cl.⁴: **B 23 K 20/02**
**B 23 K 20/10**

(30) Priorität: **28.12.84 DE 3447587**

(43) Veröffentlichungstag der Anmeldung:
**02.07.86 Patentblatt 86/27**

(84) Benannte Vertragsstaaten:
**AT BE CH DE FR GB IT LI LU NL SE**

(71) Anmelder: **Foton Production Automation GmbH**
**Präzisionsmaschinenbau**
**Notburgastrasse 5**
**D-8000 München 19(DE)**

(72) Erfinder: **Jutrzenka, Franz, Dr.**
**Dompfaffstrasse 12**
**D-8031 Eichenau(DE)**

(74) Vertreter: **Patentanwälte Grünecker, Kinkeldey,**
**Stockmair & Partner**
**Maximilianstrasse 58**
**D-8000 München 22(DE)**

(54) Maschine zum Befestigen der Verbindungsdrähte an den Anschlussstellen eines Halbleiterbauelements und des das Halbleiterbauelement aufnehmenden Gehäuses.

(57) Es wird eine Maschine zum Befestigen der Verbindungsdrähte an den Anschlußstellen eines Halbleiterbauelementes und des das Halbleiterbauelement aufnehmenden Gehäuses angegeben. Ein eine drahtzuführende Kapillare tragender Auslegerarm ist schwenkbar an einem Träger gelagert, der zur Durchführung der Schweißverbindungen auf und ab bewegt wird. Während des Bewegungsablaufes ist der Auslegerarm an dem Träger arretiert, wofür vorzugsweise ein piezoelektrisches Element herangezogen wird. Das genaue Ausmessen der Höhe des Aufsetzpunktes kann durch ein zweites piezoelektrisches Element erfolgen, das als Anschlag für den Auslegerarm wirkt und dann ein elektrisches Signal abgibt, wenn die Drahtführung auf den Anschlußfleck aufsetzt und sich der Auslegerarm als Folge davon von dem zweiten piezoelektrischen Element abhebt. Die Vorrichtung erlaubt die Erzielung hoher Arbeitsgeschwindigkeiten.

./...

FIG.1

Maschine zum Befestigen der Verbindungsdrähte an den Anschlußstellen eines Halbleiterbauelements und des das Halbleiterbauelement aufnehmenden Gehäuses

B e s c h r e i b u n g

Die Erfindung betrifft eine Maschine zum Befestigen der
Verbindungsdrähte an den Anschlußstellen eines Halbleiterbauelements und des das Halbleiterbauelement aufnehmenden
Gehäuses nach dem Oberbegriff des Patentanspruchs 1. Eine
solche Maschine ist aus der DE-AS 21 14 496 bekannt.

Die Halbleiterbauelemente, die mit einer Maschine der genannten Art behandelt werden, sind zumeist sogenannte Chips,
die hochintegrierte Halbleiterschaltkreise tragen und eine
Vielzahl von Anschlußflecken aufweisen, die mit den Anschlußstellen eines den Chip aufnehmenden Gehäuses zu verbinden sind. Wegen der geringen Abmessungen kommen hierfür
nur dünnste Drähte, besser gesagt Fäden in Betracht. In der
Praxis verwendet man hierfür Gold- oder Aluminiumfäden mit
Durchmessern in der Größenordnung von 25 μ und weniger. Ein
solcher Goldfäden verläßt die genannte Maschine durch eine
Drahtführung, die auch Kapillare genannt wird, die zugleich
die Aufgabe hat, den Faden auf die Anschlußflecken zu drükken und dadurch an diesen zu befestigen. Hierzu wird zunächst ein aus der Kapillare herausschauendes Endstück des
Goldfadens mittels eines Funkens zu einem Kügelchen verschmolzen, das anschließend von den Rändern der Kapillare
auf einen ersten Anschlußfleck gedrückt wird. Es erfolgt
dort eine Verschweißung des Kügelchens mit dem Anschlußfleck. Anschließend wird die Kapillare zum nächsten Anschlußfleck bewegt, wobei sich Goldfaden aus der Kapillare
herauszieht. Die Kapillare wird dann auf den zweiten Anschlußfleck niederbewegt, wo ihr Rand den auf ihr liegenden
Goldfaden auf den zweiten Anschlußfleck drückt und mit die-

0186176

sem verschweißt. Anschließend hebt die Kapillare wieder an und es wird nun der Goldfaden innerhalb der Maschine, d. h. oberhalb von der Kapillare festgeklemmt. Wenn dann die Kapillare weiter abgehoben wird, dann reißt der Goldfaden an der Schweißstelle am zweiten Anschlußfleck ab. Das aus der Kapillare heraushängende Ende des Goldfadens kann nun wieder mit einem Funken zu einem Kügelchen verschmolzen werden.

Da die zu bearbeitenden Halbleiterbauelemente sehr kleine Abmessungen haben, sind die Bewegungswege, die von der Kapillare auszuführen sind, sehr gering, und es ist daher möglich, die Kapillare programmgesteuert sehr schnell vom einen zum nächsten Anschlußfleck zu bewegen. Die Kapillare ist bei Maschinen dieser Art am freien Ende eines Auslegerarmes befestigt, der in einem Träger um eine horizontale, quer zu seiner Längserstreckung verlaufende Achse schwenkbar gelagert ist, und wird mittels einer Schwenkbewegung des Auslegerarmes auf den Anschlußfleck aufgesetzt. Wenn man die Arbeitsgeschwindigkeiten einer solchen Vorrichtung steigern will, dann bringen es die Länge des Auslegerarmes und die wirksamen Beschleunigungskräfte, besonders am Ende der Bewegung mit sich, daß sich der Auslegerarm durchbiegt, vibriert und/oder mit undefinierter Kraft die Kapillare auf den Anschlußfleck aufschlägt. Hierdurch besteht nicht nur die Gefahr einer Beschädigung von Kapillare und/oder bearbeitetem Bauelement, es ist auch ein definierter Schweißdruck nicht gewährleistet. Die Arbeitsgeschwindigkeit der bekannten Maschine ist daher entsprechend beschränkt.

Der Erfindung liegt die Aufgabe zugrunde, eine Maschine der eingangs genannten Art anzugeben, mit der sich höhere Arbeitsgeschwindigkeiten bei reproduzierbaren Arbeitsergebnissen erzielen lassen.

Diese Aufgabe wird gemäß der vorliegenden Erfindung durch die kennzeichnenden Merkmale des Patentanspruchs 1 gelöst. Vorteilhafte Ausführungsformen der Erfindung und ein Verfahren zum Befestigen der Verbindungsdrähte an den Anschlußstellen eines Halbleiterbauelementes und des das Halbleiterbauelement aufnehmenden Gehäuses sind Gegenstand weiterer
Ansprüche.

Von der Erfindung wird demnach eine Maschine angegeben, bei
der die Verschwenkung des Auslegerarmes an dem Träger nicht
der Heranführung und dem Abheben der Drahtführung auf bzw.
von dem Anschlußfleck dient, sondern dazu, nach dem Aufsetzen der Drahtführung auf den Anschlußfleck einen vorbestimmten Schweißdruck zu erzeugen. Während der Auf- und Abbewegung des Trägers ist der Auslegerarm an diesem arretiert,
so daß er während der schnellen Abwärtsbewegung des Trägers
nicht von seinem zweiten Anschlag abheben kann, und es kann
die Bewegung des Trägers so gesteuert werden, daß diese zunächst sehr schnell erfolgt und kurz vor dem Aufsetzen der
Drahtführung auf den Anschlußfleck kurzzeitig zur Ruhe
kommt, bevor dann unter Freigabe der Arretierung des Auslegerarmes die Abwärtsbewegung des Trägers langsamer zu Ende
geführt wird. Der Auslegerarm kann sich daher ausreichend
beruhigen und es besteht nicht die Gefahr, daß er oder das
bearbeitete Bauelement beschädigt werden.

Die Erfindung soll nachfolgend unter Bezugnahme auf die
Zeichnungen näher erläutert werden. Es zeigt:

Fig. 1     eine perspektivische Prinzipdarstellung einer Ausführungsform der Erfindung, teilweise im Schnitt;

Fig. 2     eine perspektivische Darstellung eines Ausschnitts
           aus Fig. 1 in vergrößertem Maßstab,

Fig. 3     einen Schnitt durch die Anordnung nach Fig. 2,

Fig. 4     eine Prinzipdarstellung eines Exzenterantriebes
           für die Anordnung nach Fig. 1, und

Fig. 5     eine Schaltung zum Erzeugen eines Signals beim Aufsetzen der Drahtführung auf einen Anschlußfleck.

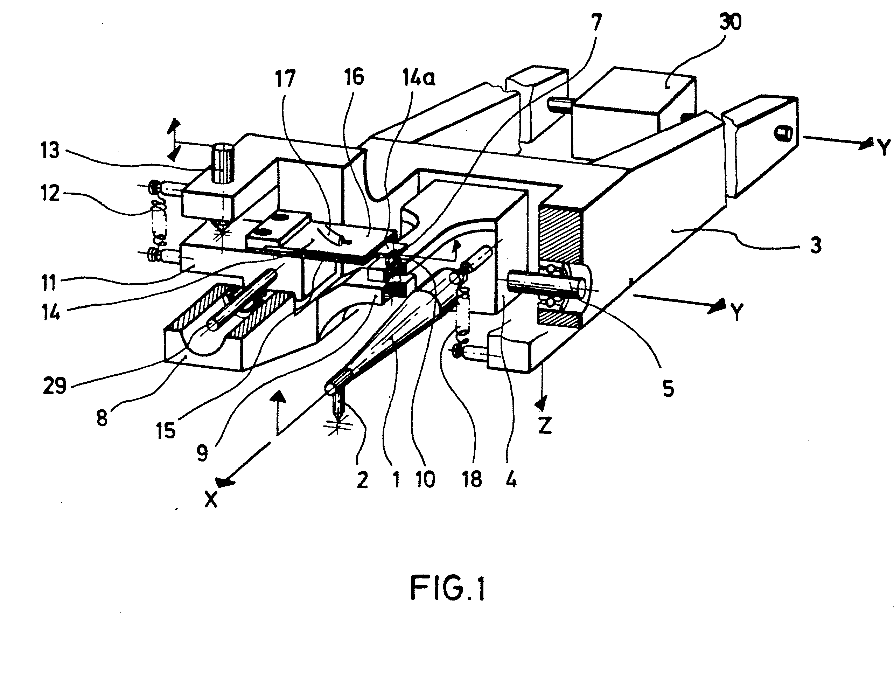

Fig. 1 zeigt einen Auslegerarm 1, der an seinem freien Ende
eine Drahtführung 2 (Kapillare) trägt und um eine quer zu
seiner Längserstreckung (X-Achse) verlaufende horizontale
Achse (Y-Achse) schwenkbar in einem Träger 3 gelagert ist.
Der Auslegerarm 1 ist hierzu in einem Halteblock 4 befestigt,
von dem sich seitlich Zapfen 5 erstrecken, die in entsprechenden Drehlagern 6 im Träger 3 gelagert sind. Vom Halteblock 4 erstreckt sich parallel zum Auslegerarm 1 ein Anschlagarm 7.

Der Träger 3 weist einen abgewinkelten Schenkel 8 auf, von
welchem eine Konsole 9 vorsteht, die unter dem Anschlagarm
7 endet. Die Konsole 9 trägt einen ersten Anschlag 10, auf
dem der Anschlagarm 7 aufliegt.

An dem Träger 3, insbesondere seinem abgewinkelten Schenkel 8 ist ein Halter 11 um eine etwa parallel zur Achse des
Auslegers 1 verlaufende Achse 29 schwenkbar gelagert. Am
Halter 11 ist eine Zugfeder 12 befestigt, die an dem Träger
3 befestigt ist und den Halter 11 gegen eine justierbare
Anschlagschraube 13 zieht. Auf dem Halter 11 ist mittels
Schrauben ein piezoelektrischer Antrieb 14 befestigt, dessen freies Ende 14a über dem Anschlagarm 7 endet und für
diesen einen zweiten Anschlag bildet. Der Anschlagarm 7 ist
auf diese Weise zwischen dem an der Konsole 9 angeordneten
Anschlag 10 und dem zweiten Anschlag 14a fest eingeklemmt,
wobei gegebenenfalls der Halter 11 von der Anschlagschraube 13 geringfügig abgehoben ist.

Der piezoelektrische Antrieb 14 besteht aus einer flexiblen
Metallzunge 15 und einem darauf befestigten piezoelektrischen Element 16. Zu letzterem ist in Fig. 1 das Ende einer
Anschlußleitung 17 erkennbar. Wenn der piezoelektrische Antrieb erregt wird, zieht sich das piezoelektrische Element 16 zusammen mit der Folge, daß die aus ihm und der Metallzunge bestehende Anordnung sich nach oben durchbiegt und damit dem Anschlagarm 7 zwischen dem ersten Anschlag 10 und dem zweiten Anschlag 14a ein gewisses Spiel einräumt.

Der Träger 3 ist an langem Hebel um die Y-Achse schwenkbar in einem Maschinengestell gelagert, das in Fig. 1 durch einen Lagerbock 30 repräsentiert ist. Der Träger 3 ist durch einen in Fig. 1 nicht dargestellten Antrieb quer zur Richtung der X- und Y-Achsen, also etwa parallel zur Z-Achse auf und ab antreibbar. Die Bewegung der Kapillare 2 am Ende des Auslegerarmes 1 beträgt dabei nur wenige mm, so daß aufgrund des langen Hebelarms von einer nahezu linearen Bewegung parallel zur Z-Achse gesprochen werden kann. Der Antrieb ist zweckmäßigerweise ein Exzenterantrieb. Der Träger 3 sollte sich in der Höhe in bezug auf den Exzenter so einjustieren lassen, daß die tiefste Lage der Kapillare 2 exakt eingestellt werden kann.

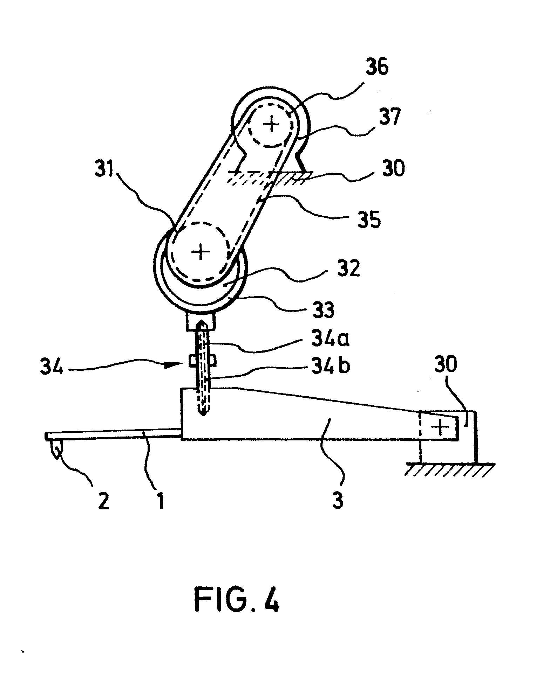

Einen solchen Exzenterantrieb zeigt in groben Umrissen die Fig. 4. Er besteht aus einem im Maschinengestell drehbar gelagerten Zahnrad 31 und einer drehfest, aber exzentrisch mit letzterem verbundenen runden Scheibe 32, die auf ihrem Umfang einen auf ihr drehbaren Lagerring 33 trägt. Zwischen der Scheibe 32 und dem Lagerring 33 kann sich ein Kugellager geringsten radialen Spiels befinden. Der Lagerring 33 ist mit dem Träger 3 mittels einer Einstellschraube 34 verbunden, die zwei Abschnitte 34a und 34b unterschiedlicher Steigungshöhe oder Steigungsrichtung aufweist. Mit ihrer Hilfe läßt sich die Distanz zwischen dem Lagerring 33 und dem Träger 3 verstellen. Das Zahnrad 31 ist mittels eines Zahnriemens 35 mit einem Antriebszahnrad 36 verbunden, das auf der Welle eines Schrittmotors 37 drehfest angebracht ist, der im Maschinengestell befestigt ist.

Zwischen dem Halteblock 4 und dem Träger 3 ist eine Feder 18 eingespannt, die den Anschlagarm 7 auf den ersten Anschlag 10 drückt. Die Kapillare 2 wird dadurch in einer definierten unteren Stellung gehalten.

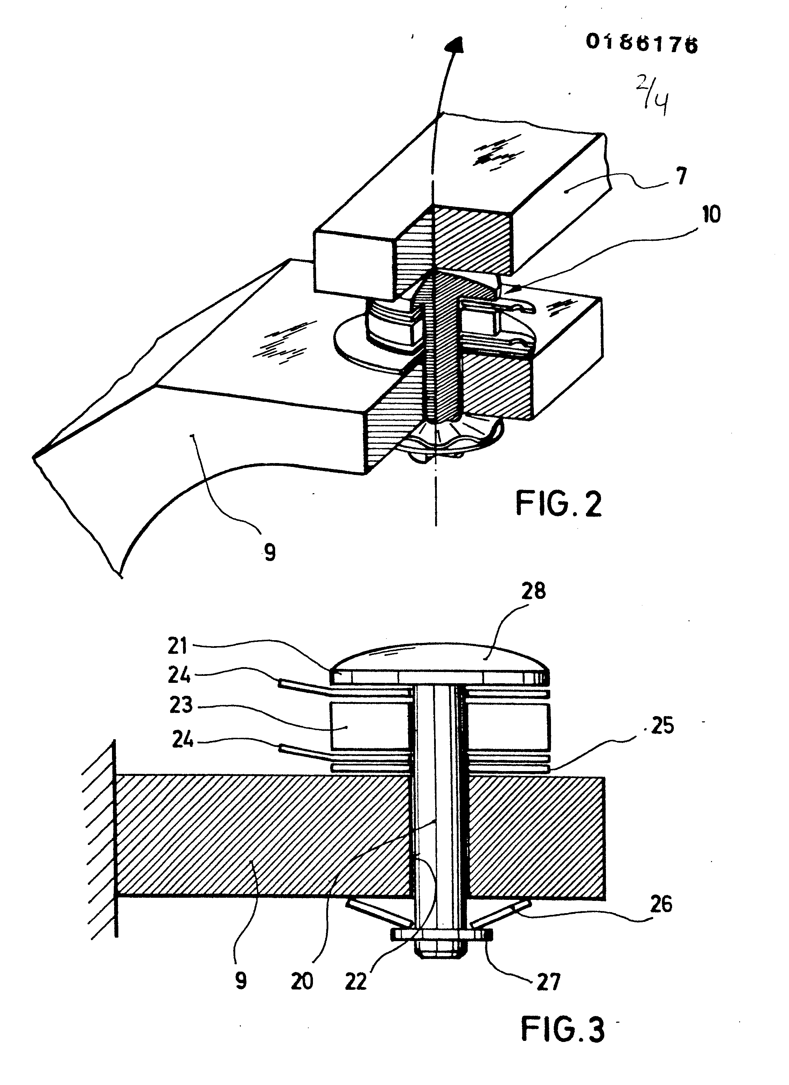

Der erste Anschlag 10, der an der Konsole 9 angeordnet ist, besteht gemäß Fig. 2 und 3 aus einem Bolzen 20 mit Kopf 21. Der Bolzen durchdringt lose eine Bohrung 22 in der Konsole 9. Zwischen seinem Kopf 21 und der Konsole 9 sind sandwichartig ein Piezoelement 23 mit Anschlußelektroden, beispielsweise CuBe (24) und eine Glimmerisolierscheibe 25 angeordnet. Letztere isoliert das eine Anschlußblech 24 gegen die Konsole. Gegebenenfalls kann eine weitere Glimmerisolierscheibe auch zwischen dem oberen Anschlußblech und dem Bolzenkopf 21 angeordnet sein. Der Bolzen 20 durchdringt die Bohrung 22 in der Konsole 9 vollständig und ist an seinem freien Ende mittels einer Federscheibe 26 und einer Wellensicherung 27 gesichert. Das piezoelektrische Element 23 ist ein Dickenschwinger. Zweckmäßigerweise ist auf dem Bolzenkopf 21 eine Aluminiumoxydkappe 28 als Verschleißsicherung aufgebracht.

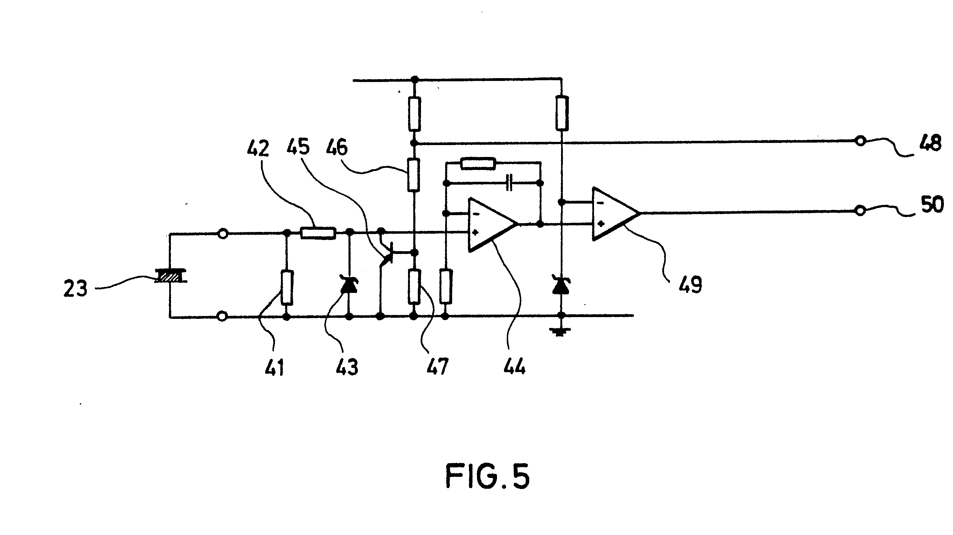

Das Piezoelement 23 ist Bestandteil eines elektrischen Schaltkreises, der in Fig. 5 dargestellt ist. Dieser Schaltkreis ist dazu bestimmt, zu verhindern, daß sich die Elektroden am Piezoelement 23 infolge von Erschütterungen, denen die Anordnung im Betrieb ausgesetzt ist, aufladen. Dem Piezoelement 23 ist ein sehr hochohmiger Widerstand parallelgeschaltet, der eine Größe von beispielsweise 47 M$\Omega$ aufweist, der eine langsame Entladung der Elektroden des Piezoelementes sicherstellen soll. Weiterhin ist mit dem Piezoelement über einen Widerstand 42 eine Zenerdiode 43 verbunden, die vom Piezoelement 23 ausgehende Impulse negativer Polarität kurzschließt. Der Verbindungspunkt wie zwischen dem Widerstand 42 und der Zenerdiode 43 ist mit dem positiven Eingang eines Operationsverstärkers 44 verbunden. Parallel zur Zenerdiode 43 liegt die Emitterkollektorstrecke eines Transistors 45, dessen Basis am Teilerpunkt einer Spannungsteilerschaltung, bestehend aus Widerständen 46 und 47 liegt. Der Eingang der Spannungsteilerschaltung ist mit einem Ausgang 48 der Programmsteuerung (nicht dargestellt) verbunden. Der Ausgang des Operationsverstärkers 44 ist mit dem positiven Eingang eines weiteren Operationsverstärkers 49 verbunden, dessen Ausgang mit einem Eingang 50 der Programmsteuerung verbunden ist. Die weitere Beschaltung der Operationsverstärker 44 und 49 ist zur Erläuterung der Erfindung nicht von Interesse.

Wenn am Ausgang 48 der Programmsteuerung ein Signal ansteht, dann wird der Transistor 45 leitfähig und legt den positiven Eingang des Operationsverstärkers 44 an Masse. Gleichzeitig schließt er über den Widerstand 42 die Elektroden des Piezoelementes 23 kurz. Ist an dem Ausgang 48 keine Spannung vorhanden, dann ist der Transistor 45 gesperrt und am Piezoelement 23 etwa erzeugte Spannungen können in den Operationsverstärker 44 gelangen.

Der Zweck der einzelnen Elemente der Maschine soll nachfolgend unter Bezugnahme auf die Beschreibung einer bevorzugten Arbeitsweise der Maschine näher erläutert werden.

Es ist im Betrieb wichtig, daß die Drahtführung (Kapillare) 2 ohne Prellen auf den Anschlußfleck aufgesetzt und mit ihr eine exakt festgelegte Schweißkraft, die üblicherweise in der Größenordnung von etwa 0,3 N liegt, auf den Anschlußfleck bzw. den zwischen ihr und dem Anschlußfleck befindlichen Golddraht ausgeübt wird. Die vorliegende Maschine ist so eingerichtet, daß der Anschlagarm 7 von der Feder 18 mit einer genau definierten Kraft auf den ersten Anschlag 10 gedrückt wird. Es ist daher eine an der Kapillare 2 angreifende Kraft, die notwendig ist, um den Anschlagarm 7 vom Anschlag 10 abzuheben, ebenso genau definiert.

Im Betrieb wird mit der Maschine zunächst eine Einstellung auf die Höhenlage der Anschlußflecken vorgenommen. Dazu wird in der tiefsten Stellung, die der Antrieb für den Träger 3 diesem vermitteln kann, der Träger 3 mittels der Einstellschraube 34 so eingestellt, daß die Kapillare 2 auf einem
Anschlußfleck gerade eben aufliegt. Die Kontrolle dessen
erfolgt mit Hilfe des piezoelektrischen Elements 23, das
Bestandteil des ersten Anschlags 10 ist. Während der Bewegung des Trägers 3 steht zunächst an dem Ausgang 48 der
Programmsteuerung ein Signal an, so daß der Transistor 45
leitfähig ist und Ausgangssignale des Piezoelementes 23,
die durch Erschütterungen hervorgerufen sein könnten, kurzgeschlossen werden. Wenn der Träger 3 zur Ruhe gekommen ist,
kurz bevor die Kapillare 2 auf einem Anschlußfleck aufliegt,
wird die Spannung am Ausgang 48 aufgehoben, so daß der Transistor 45 gesperrt wird. Wird nun die Kapillare 2 auf den
Anschlußfleck aufgesetzt, wird das Piezoelement 23 entlastet und gibt als Folge davon ein elektrisches Signal ab,
das durch die Operationsverstärker 44 und 49 verstärkt dem
Eingang 50 der Programmsteuerung zur Verfügung gestellt
wird. Dieses Signal kann für Anzeigezwecke verwendet werden, was dem Bedienungspersonal anzeigt, daß der gesuchte
Punkt erreicht ist. Gegebenenfalls kann nun die Einstellschraube 34 noch etwas weiter verdreht werden, etwa um den
Träger 3 um weitere ein oder zwei Hundertstel Millimeter
weiter abzusenken.

Voraussetzung für die Entlastung des piezoelektrischen Elementes 23 im ersten Anschlag 10 ist, daß der Auslegerarm 1
gegenüber dem Träger 3 verschwenkt werden kann, d.h. die
durch den zweiten Anschlag 14a erzeugte Arretierung am Anschlagarm 7 gelöst ist. Zu diesem Zweck ist, zum geeigneten
Zeitpunkt durch Programm gesteuert, das piezoelektrische
Element 16 so erregt, daß die Anordnung 14 nach oben durchgebogen ist und der Anschlag 14a den Auslegerarm 7 freigibt. Der von der Anordnung 14 gebildete Antrieb ist im
Ruhezustand mittels der Einstellschraube 13 so eingestellt,
daß er den Auslegerarm 7 sicher zwischen den beiden Anschlägen 10 und 14a festklemmt.

Nachdem die Anordnung insgesamt einjustiert ist, kann mit ihr gearbeitet werden. Im Betrieb senkt der Antrieb für den Träger 3 diesen, gesteuert durch eine Programmsteuerung mit großer Geschwindigkeit soweit ab, daß die Kapillare 2 den Anschlußfleck auf dem Bauelement oder dem Gehäuse beinahe berührt. Es wird dann das piezoelektrische Element 16 derart betätigt, daß es sich nach oben durchbiegt und den Anschlagarm 7 und somit den Auslegerarm 2 freigibt. Der den piezoelektrischen Antrieb 14 tragende Halter 11 wird durch die Kraft der Feder 12 um die Achse 29 gekippt und liegt an der Anschlagschraube 13 an. Es folgt dann die Fortsetzung der Abwärtsbewegung des Trägers 3 mit verringerter Geschwindigkeit bis zum Ende des Bewegungstaktes, wobei die Kapillare 2 mit dem Anschlußfleck in Berührung gelangt und anschließend gegen die Kraft der Feder 18 der Anschlagarm 7 von dem ersten Anschlag 10 abgehoben wird. Da dieser das piezoelektrische Element 23 einschließt, kann somit, sofern es gewünscht wird, während der laufenden Arbeit stets geprüft werden, ob die Kapillare auch tatsächlich in geeigneter Weise mit den Anschlußflecken in Berührung gelangt ist.

Anschließend wird der Träger 3 wieder angehoben, wobei unmittelbar nach dem Augenblick, zu welchem die Kapillare den Anschlußfleck verlassen hat, der Antrieb 14 den Anschlag 14a von oben auf den Anschlagarm 7 drückt und diesen am Träger 3 somit festlegt. Diese Bewegung des Antriebes 14a läßt sich durch ein vom piezoelektrischen Element 23 geliefertes Signal steuern, das gleichzeitig mit oder unmittelbar nach dem Abheben der Kapillare 2 vom Anschlußfleck erzeugt wird.

Der Vorteil des Einsatzes des piezoelektrischen Antriebes 14 zum Arretieren des Auslegerarmes 1 liegt darin, daß sich mit ihm sehr große Ansprechgeschwindigkeiten erreichen lassen, die sich beispielsweise mit Elektromagneten nicht oder nur unter Inkaufnahme beachtlicher Nachteile erzielen lassen.

Der Einsatz des piezoelektrischen Elementes 23 im ersten Anschlag 10 erlaubt es, den Betrieb des die Arretierung des Auslegerarmes 1 bewirkenden Antriebes 14 zu steuern und außerdem das ordnungsgemäße Betriebsverhalten der Gesamtvorrichtung im Betrieb laufend zu überwachen. So werden insbesondere beispielsweise bei unterschiedlichen Höhen der Anschlußflecken von dem piezoelektrischen Element 23 Signale zu wechselnden Zeitpunkten innerhalb des Betriebszyklus erzeugt, was als Hinweis vom Bedienungspersonal oder auch automatisch ausgewertet werden kann, beispielsweise um den Betrieb zu unterbrechen oder die Maschine automatisch nachzustellen.

GRÜNECKER, KINKELDEY, STOCKMAIR & PARTNER

PATENTANWÄLTE
EUROPEAN PATENT ATTORNEYS

0186176

A GRUNECKER DIPL -ING
DR H KINKELDEY DIPL -ING
DR W STOCKMAIR DIPL -ING AE I CALTECH
DR K SCHUMANN DIPL -PHYS
P H JAKOB DIPL -ING
DR G BEZOLD DIPL -CHEM
W MEISTER DIPL -ING
H HILGERS DIPL -ING
DR H MEYER-PLATH DIPL -ING
DR M BOTT-BODENHAUSEN DIPL -PHYS
DR U KINKELDEY DIPL -BIOL

LICENCE EN DROIT DE L UNIV DE GENÈVE

8000 MUNCHEN 22
MAXIMILIANSTRASSE 58

Foton Production Automation
GmbH Präzisionsmaschinenbau
Notburgastraße 5
8000 München 19

EP 2749-50/to

Maschine zum Befestigen der Verbindungsdrähte an den Anschlußstellen eines Halbleiterbauelements und des das Halbleiterbauelement aufnehmenden Gehäuses

P a t e n t a n s p r ü c h e

1. Maschine zum Befestigen der Verbindungsdrähte an den Anschlußstellen eines Halbleiterbauelements und des das Halbleiterbauelement aufnehmenden Gehäuses, mit einem an seinem freien Ende eine Drahtführung tragenden Auslegerarm, der um eine quer zu seiner Längserstreckung (X-Achse) verlaufende horizontale Achse (Y-Achse) schwenkbar an einem verstellbaren Träger gelagert ist und unter dem Einfluß einer ersten Antriebseinrichtung die Drahtführung auf eine Anschlußstelle aufsetzt und davon abhebt, dadurch g e - k e n n z e i c h n e t , daß der Träger (3) in einer senkrecht zur X- und Y-Achse verlaufenden Richtung (Z-Achse) oszillierend beweglich gelagert ist, daß der Auslegerarm (1) starr mit einem Anschlagarm (7) verbunden ist, dem ein erster, mit dem Träger (3) fest verbundener Anschlag (10) und - in entgegengesetzter Wirkungsrichtung - ein zweiter, unter dem Einfluß einer zweiten elektrischen Antriebseinrichtung (14) beweglicher, am Träger (3) gelagerter Anschlag (14a) gegenüberstehen, wobei die Anschläge (10, 14a) in bezug auf den Anschlagarm (7) so eingestellt sind, daß dieser in Abhängigkeit von dem Zustand der elektrischen Antriebseinrichtung (14) an dem Träger (3) unbeweglich festgelegt bzw. gegenüber jenem schwenkbar ist.

2. Maschine nach Anspruch 1, dadurch g e k e n n - z e i c h n e t , daß die zweite Antriebseinrichtung (14) ein piezoelektrisches Element (16) enthält.

3. Maschine nach Anspruch 2, dadurch g e k e n n - z e i c h n e t , daß das piezoelektrische Element (16) ein streifenförmiger Längsschwinger ist, der auf einem flexiblen Metallstreifen (15) aufgeklebt ist, mit diesem einenends festeingespannt ist und mit dem anderen Ende den beweglichen Anschlag (14a) bildet.

4. Maschine nach Anspruch 2 oder 3, dadurch g e k e n n - z e i c h n e t , daß der zweite elektrische Antrieb (14) an einem Halter (11) befestigt ist, der an dem Träger (3) justierbar befestigt ist.

5. Maschine nach Anspruch 3 und 4, dadurch g e k e n n - z e i c h n e t , daß der Halter (11) um eine in X-Richtung verlaufende Achse schwenkbar gelagert ist und das piezoelektrische Element (16) sich im wesentlichen in Y-Richtung erstreckt.

6. Maschine nach einem der vorhergehenden Ansprüche, dadurch g e k e n n z e i c h n e t , daß der erste Anschlag (10) ein piezoelektrisches Element (23) enthält.

7. Maschine nach Anspruch 6, dadurch g e k e n n - z e i c h n e t , daß der erste Anschlag (10) besteht aus einem eine Bohrung (22) in einer trägerseitigen Konsole (9) durchdringenden Bolzen (20) mit Bolzenkopf (21), einem zwischen dem Bolzenkopf (21) und der Konsole (9) sandwichartig angeordneten piezoelektrischen Dickenschwinger (23) mit beidseitigen Anschlußelektroden (24) und Isolierscheibe(n) (25), sowie einer Federscheibe (26) und einer Wellensicherung (27) auf dem aus der Konsole (9) hervorstehenden Ende des Bolzens (20).

8. Maschine nach einem der vorhergehenden Ansprüche, dadurch g e k e n n z e i c h n e t , daß der Anschlagarm (7) mittels einer Feder (18) gegen den ersten Anschlag (10) gedrückt ist, die zwischen der aus Auslegerarm (1) und Anschlagarm (7) bestehenden Baugruppe und dem Träger (3) eingespannt ist.

9. Maschine nach einem der Ansprüche 1 bis 7, dadurch g e k e n n z e i c h n e t , daß der Anschlagarm (7) mittels eines Magneten gegen den ersten Anschlag (10) gedrückt ist, der an dem Träger (3) befestigt ist.

10. Maschine nach einem der vorhergehenden Ansprüche, dadurch g e k e n n z e i c h n e t , daß der Träger (3) von einem Exzenter in oszillierende Bewegung versetzt ist und daß die Tiefststellung der oszillatorischen Bewegung einstellbar ist.

11. Verfahren zum Befestigen der Verbindungsdrähte an den Anschlußstellen eines Halbleiterbauelementes und des das Halbleiterbauelement aufnehmenden Gehäuses mittels einer Maschine mit einem an seinem freien Ende eine Drahtführung tragenden Auslegerarm, der um eine quer zu seiner Längserstreckung (X-Achse) verlaufende horizontale Achse (Y-Achse) schwenkbar an einem verstellbaren Träger gelagert ist und unter dem Einfluß einer Antriebseinrichtung die Drahtführung auf eine Anschlußstelle aufsetzt und davon abhebt, dadurch g e k e n n z e i c h n e t , daß die Aufsetz- und Abhebebewegung der Drahtführung an dem Auslegerarm durch Absenken und Anheben des den Auslegerarm lagernden Trägers ausgeführt wird, daß der Auslegerarm im wesentlichen während der gesamten Trägerbewegung an diesem unbeweglich arretiert ist und erst kurz vor dem Aufsetzen der Drahtführung auf einen Anschlußfleck aus der Arretierung gelöst und nach dem Aufsetzen auf den Anschlußfleck bis zum Ende der Absenkbewegung des Trägers gegenüber diesem gegen die Kraft einer Vorspanneinrichtung verschwenkt wird.

FIG.1

0186176

2/4

FIG.2

FIG.3

FIG. 4

FIG.5

0186176

4/4